# EUROPEAN PATENT APPLICATION

(11) **EP 4 760 319 A1**
(43) Date of publication of application: **17.06.2026**
(21) Application number: 24879875.3
(22) Date of filing: 27.05.2024
(51) Int. Cl.: G01R 31/52, G01R 31/389, G01R 27/02, G01R 27/08, G01R 31/392, H01M 10/42

(54) **APPARATUS FOR MEASURING INSULATION PERFORMANCE OF BATTERY**

(30) Priority: 19.10.2023 KR 20230140199
(71) Applicant: SK On Co., Ltd., Seoul 03161 (KR)
(72) Inventor: LEE, Doo-Yeong, Daejeon 34124 (KR); KIM, Tae-Hyeon, Daejeon 34124 (KR); SEO, Jeong-Myeong, Daejeon 34124 (KR)
(74) Representative: Stolmár & Partner Patentanwälte PartG mbB
(86) International application number: PCT/KR2024/007179
(87) International publication number: WO 2025/084532

(57) **Abstract**

An apparatus for measuring the insulation performance of a battery, according to an embodiment of the present disclosure, comprises: a support plate including an insulated insulation region; a close contact member disposed in the insulation region, including a material thereof having electrical conductivity and elasticity, and being in close contact with a battery cell; and a resistance measuring device in which a first connection part is connected to the close contact member and a second connection part is connected to the battery cell, wherein the close contact member is pressed by the battery cell so that at least a portion of the close contact member may be deformed into a shape corresponding to the outer contour of the battery cell.

## Description

### Technical Field

The present disclosure relates to an apparatus for measuring insulation performance of a battery.

### Background Art

Batteries are widely used in small electronic devices such as mobile phones, laptop computers, or the like, as well as medium- to large-sized mechanical devices such as electric vehicles (EV) or the like, and offer the advantages of being rechargeable and reusable.

A battery may be manufactured in a form of a battery cell by housing an electrode assembly including a positive electrode plate, a negative electrode plate, and a separator in a case, injecting an electrolyte into the case, and then sealing the case.

A plurality of battery cells may be assembled to form a battery module, and a plurality of battery modules may also be assembled to form a battery pack. In constructing the battery module or the battery pack, the plurality of battery cells may be stacked in a module case or a pack case.

When there are minute defects or scratches in the case of the battery cell, insulation performance of the battery cell may be significantly degraded.

Therefore, an operation of measuring insulation performance of battery cells, not only in individual battery cells, but also in units of battery modules and battery packs, may be a very important problem for improving battery safety.

### Disclosure of Invention

### Technical Problem

According to an aspect of the present disclosure, insulation performance of a battery cell, a battery module, and a battery pack may be measured.

Furthermore, according to an aspect of the present disclosure, efficiency and convenience of an operation of measuring insulation performance of a battery cell, a battery module, and a battery pack may be improved.

Furthermore, according to an aspect of the present disclosure, reliability of results of measuring insulation performance of a battery cell, a battery module, and a battery pack may be improved.

Furthermore, the present disclosure may be widely applied to devices within green technology fields such as devices for solar power generation, wind power generation, or the like.

Furthermore, the present disclosure may be applied to eco-friendly devices such as eco-friendly electric vehicles, hybrid vehicles, or the like that ameliorate the effects of climate change by suppressing air pollution and greenhouse gas emissions.

### Solution to Problem

An apparatus for measuring insulation performance of a battery, according to an embodiment of the present disclosure, includes a support plate including an insulated insulation region; a close contact member disposed in the insulation region, including a material having electrical conductivity and elasticity, and in close contact with a battery cell; and a resistance measuring device in which a first connection portion is connected to the close contact member, and in which a second connection portion is connected to a battery cell, wherein the close contact member is pressed by the battery cell so that at least a portion of the close contact member is deformed into a shape corresponding to an outer contour of the battery cell.

In an embodiment, a plurality of battery cells may be in contact with the close contact member, and the close contact member may be pressed in a first direction by the plurality of battery cells to expand in a direction, different from the first direction, to press the plurality of battery cells.

In an embodiment, the close contact member may be in contact with two or more surfaces, among surfaces of one battery cell.

In an embodiment, a jig unit including a fixation region on which the battery cell is seated, and provided to change a volume of the fixation region may be further included.

In an embodiment, the jig unit may include a first support block fixed to the support plate; a second support block disposed to oppose the first support block to form the fixation region between the first support block and the second support block; and a gap adjusting member provided to pass through the first and second support blocks in a second direction and change a width of the fixation region in the second direction.

In an embodiment, the first support block may include a plurality of first side support blocks having a first coupling hole formed therein, and the gap adjusting member inserted into the first coupling hole; and a first connection block provided to connect the plurality of first side support blocks and change a distance between the plurality of first side support blocks in a third direction, and the second support block may include a plurality of second side support blocks having second coupling holes formed therein to oppose the first coupling holes, and the gap adjusting member inserted into the second coupling holes; and a second connection block provided to connect the plurality of second side support blocks and change a distance between the plurality of second side support blocks in the third direction.

In an embodiment, the first connection block may include a first key block protruding from at least one surface among surfaces opposing the plurality of first side support blocks, the second connection block may include a second key block protruding from at least one surface among surfaces opposing the plurality of second side support blocks, and the first key block and the second key block may be coupled to or separated from the first side support block and the second side support block.

In an embodiment, at least one of the plurality of first side support blocks may include a first key groove into which the first key block is inserted, and at least one of the plurality of second side support blocks may include a second key groove into which the second key block is inserted.

In an embodiment, a screw groove may be formed in a first coupling hole, and the gap adjusting member may include a screw thread corresponding to the screw groove.

In an embodiment, at least one of the first side support block and the second side support block may include a dimension measuring unit.

In an embodiment, the dimension measuring unit may be a scale line visually displayed on at least one of the first side support block and the second side support block.

In an embodiment, a backup member provided between the support plate and the close contact member and formed of a material having elasticity may be further included.

In an embodiment, modulus of elasticity of the backup member may be less than modulus of elasticity of the close contact member.

In an embodiment, a thickness of the backup member may be greater than a thickness of the close contact member.

In an embodiment, the close contact member may include an electrically conductive rubber.

In an embodiment, the close contact member may have a thickness of 10 mm or more and 30 mm or less.

In an embodiment, the close contact member may include an electrically conductive rubber, and a thickness of the close contact member may be 0.5 mm or more and 2 mm or less.

Meanwhile, an apparatus for measuring insulation performance of a battery, according to another embodiment of the present disclosure, includes a support plate including an insulated insulation region; a close contact member disposed in the insulation region, formed of a material having electrical conductivity and elasticity, and in close contact with a battery module including a plurality of battery cells; and a resistance measuring device in which a first connection portion is connected to the close contact member, and in which a second connection portion is connected to a terminal portion of the battery module, wherein the close contact member is pressed by at least one of the plurality of battery cells and a pad member disposed between the plurality of batteries, to be deformed to correspond to an outer contour of at least a portion of the plurality of battery cells and the pad member.

### Advantageous Effects of Invention

According to the present disclosure, insulation performance of a battery cell, a battery module, and a battery pack may be measured.

Furthermore, according to an aspect of the present disclosure, efficiency and convenience of an operation of measuring insulation performance of a battery cell, a battery module, and a battery pack may be improved.

Furthermore, according to an aspect of the present disclosure, reliability of results of measuring insulation performance of a battery cell, a battery module, and a battery pack may be improved.

Furthermore, the present disclosure may be widely applied to devices within green technology fields such as solar power generation, wind power generation, or the like.

Furthermore, the present disclosure may be applied to eco-friendly devices such as eco-friendly electric vehicles, hybrid vehicles, or the like that prevent climate change by suppressing air pollution and greenhouse gas emissions.

### Brief Description of Drawings

FIG. 1 is a perspective view of an apparatus for measuring insulation performance of a battery according to an embodiment of the present disclosure.
FIG. 2 is a left side view of a portion of FIG. 1.
FIG. 3 schematically illustrates a state in which a plurality of battery cells are seated to a close contact member.
FIG. 4 is an enlarged view of portion 'A' in FIG. 3.
FIG. 5 is a perspective view of an apparatus for measuring insulation performance of a battery according to another embodiment of the present disclosure.
FIG. 6 is an exploded perspective view of a jig unit according to an embodiment of the present disclosure.
FIG. 7 is an operating status diagram of a jig unit according to an embodiment of the present disclosure.
FIG. 8 is an operating status diagram of a jig unit according to an embodiment of the present disclosure.
FIG. 9 is an exploded perspective view of a jig unit according to another embodiment of the present disclosure.
FIG. 10 is a partially exploded perspective view of an apparatus for measuring insulation performance of a battery according to another embodiment of the present disclosure.
FIG. 11 is a partially exploded perspective view of an apparatus for measuring insulation performance of a battery according to another embodiment of the present disclosure.
FIG. 12 schematically illustrates a state in which a plurality of battery cells are seated to a close contact member.
FIG. 13 schematically illustrates a state in which an apparatus for measuring insulation performance of a battery according to another embodiment of the present disclosure measures insulation performance of a battery module.
FIG. 14 schematically illustrates a state in which an apparatus for measuring insulation performance of a battery according to another embodiment of the present disclosure measures insulation performance of a battery module.

### Best Mode for the Invention

To facilitate understanding of the description of the embodiments of the present disclosure, elements denoted by the same reference numerals in the accompanying drawings may be identical elements. Some components in the attached drawings may be exaggerated, omitted, or schematically illustrated, and the sizes of each component do not fully reflect the actual size.

Furthermore, to clarify the gist of the present disclosure, descriptions of elements and techniques well known in the art will be omitted. Hereinafter, the present disclosure will be described in detail with reference to the attached drawings.

However, the spirit of the present disclosure is not limited to the presented embodiments, and those skilled in the art may propose other forms in which specific components may be added, modified, or deleted, but it may be to be understood that such forms also fall within the scope of the present disclosure.

Hereinafter, in the drawings, an X-axis represents a thickness direction of a battery cell (10), a Y-axis represents a width direction of the battery cell (10), and a Z-axis represents a height direction of the battery cell (10). However, these directions may be arbitrarily set for convenience of explanation, and the aforementioned directions may be changed.

The meaning of a battery may include at least one of one battery cell (10), a battery module (200) including a plurality of battery cells (10), or a battery pack including the plurality of battery cells (10).

The battery cell (10) may have a form in which a positive electrode plate, a negative electrode plate, and a separator are stacked in an outer case, an electrolyte is injected therein, and the same is sealed. In this case, an electrode lead (11) connected to the positive electrode plate and exposed to an external space of the outer case may be a positive electrode lead (11a), and an electrode lead (11) connected to the negative electrode plate and exposed to an external space of the outer case may be a negative electrode lead (11b). The battery cell (10) may have a unidirectional cell form in which the positive electrode lead (11a) and the negative electrode lead (11b) are drawn out from the outer case in the same direction, or a bidirectional cell form in which the positive electrode lead (11a) and the negative electrode lead (11b) are drawn out from the outer case in different directions. A battery cell applicable to the present disclosure may include both unidirectional and bidirectional cells, but the following description will focus on bidirectional cells as an example.

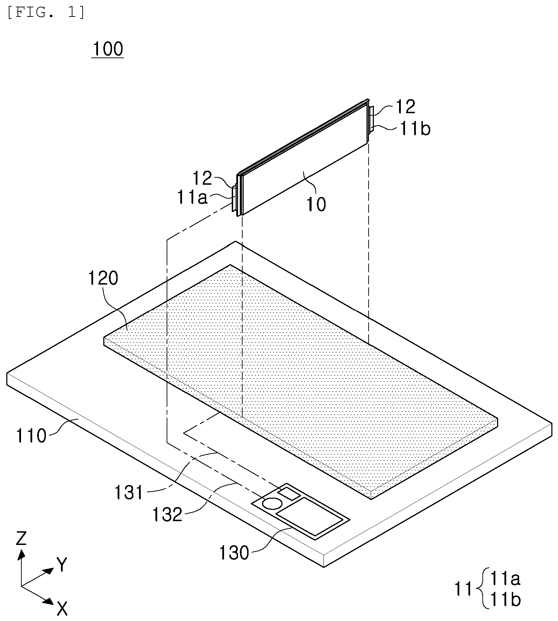

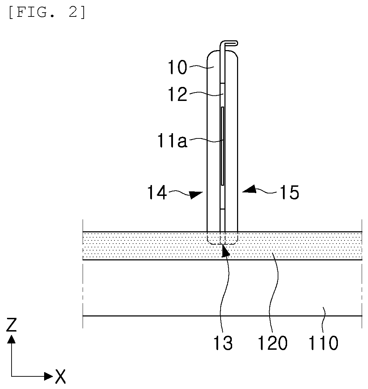

FIG. 1 is a perspective view of an apparatus (100) for measuring insulation performance of a battery according to an embodiment of the present disclosure, and FIG. 2 is a left side view of a portion of FIG. 1. As illustrated in FIGS. 1 and 2, an apparatus (100) for measuring insulation performance of a battery may include a support plate (110) including an insulated insulation region, a contact member (120) disposed in the insulation region, including a material having electrical conductivity and elasticity, and in close contact with a battery cell (10), and a resistance measuring device (130) in which a first connection portion (131) is connected to the close contact member (120) and in which a second connection portion (132) is connected to the battery cell (10), wherein the close contact member (120) may be pressed by the battery cell (10) so that at least a portion of the close contact member is deformed into a shape corresponding to an outer contour of the battery cell (10).

The outer contour of the battery cell (10) may be an edge of the battery cell. In an embodiment, a shape of a region of the close contact member (120) contacting the battery cell (10) may be a form in which a shape of the edge of the battery cell (10) is copied. In addition, in an embodiment, the close contact member (120) may be recessed so that the shape of the region contacting the battery cell (10) is identical to the shape of the edge of the battery cell (10) formed in a negative shape.

The support plate (110) may be formed of a material of which itself is insulated or may include at least one insulated plane. For example, the support plate (110) may have one surface disposed to be parallel to an X-Y plane is provided as an insulation region. An insulating material may be applied to the insulation region of the support plate (110). The insulation region of the support plate (110) may be provided by applying at least one material selected from the group consisting of mica, an insulating rubber (rubber insulator), and polypropylene to one surface of the support plate (110). A type of the insulating material is not necessarily limited by the present disclosure, and may be replaced with another insulating material. When the support plate (110) itself is provided with an insulating material, the support plate (110) may be provided with a material including polypropylene.

The close contact member (120) may be fixed to the insulation region of the support plate (110). The close contact member (120) may be adhered to the support plate (110) using an adhesive tape, glue, or the like, or may be fixed to the support plate (110) using a component such as a bolt, a pin, or the like.

The close contact member (120) may be provided with a material having electrical conductivity and elasticity. In an embodiment, the close contact member (120) may be provided with a material including conductive rubber. The conductive rubber may be obtained by mixing rubber with a conductive material such as metal, carbon, or the like. This is not necessarily limited by the present disclosure, and the conductive rubber may be formed using various other methods.

When the close contact member (120) is provided with a material including conductive rubber, the close contact member (120) may be fixed without slipping on the support plate (110) by surface friction without any additional adhesive.

The first connection portion (131) of the resistance measuring device (megger, 130) may be electrically connected to the close contact member (120), and the second connection portion (132) may be electrically connected to the battery cell (10). The resistance measuring device (130) may be fixed to the support plate (110) or may be located outside the support plate (110). The first connection portion (131) and the second connection portion (132), which may be electrical connection portions of the resistance measuring device (130), should be connected to the close contact member (120) and the battery cell (10).

The resistance measuring device (130) may measure leakage current and applied voltage by applying voltage to the battery cell (10). Insulation resistance (R) may be determined from measured leakage current (I) and applied voltage (V). The insulation resistance (R) may be calculated using Ohm's law (V=IR).

A magnitude of voltage applied by the resistance measuring device (130) may be preset by an operator, and the resistance measuring device (130) may apply the preset voltage to the battery cell (10). The resistance measuring device (130) may then measure the leakage current flowing through the battery cell (10) and the close contact member (120), thereby visually displaying an insulation resistance value.

A type of resistance measuring device (130) is not necessarily limited by the present disclosure, but among existing products, when a portable type resistance measuring device (130) using a battery is used, mobility of the apparatus (100) may be secured and the apparatus may be easily stored.

An operation of measuring insulation resistance may be performed by contacting the battery cell (10) and the close contact member (120) and applying voltage using the resistance measuring device (130). An insulation resistance value measured by the resistance measuring device (130) may be used to measure and determine insulation performance of the battery cell (10).

The may have an electrode lead (11) protrudes toward the external space of the battery cell (10), and the electrode lead (11) may be insulated from the outer case of the battery cell (10) by an insulating member (12). In an embodiment, the battery cell (10) may have a bidirectional cell configuration in which a positive electrode lead (11a) protrudes in a -Y direction and a negative electrode lead (11b) protrudes in a +Y direction. In this case, protruding directions of the positive electrode lead (11a) and the negative electrode lead (11b) may be reversed.

In an embodiment, the battery cell (10) may be a pouch-type battery cell (10). The outer case of the pouch-type battery cell (10) may be a film in which polyethylene terephthalate (PET), nylon, and aluminum are stacked.

A single film of the outer case of the battery cell (10) may be folded so that both end portions are in contact, and three edges, excluding an edge in which a fold line is formed, may overlap and be heat-sealed to form a sealed structure.

Electrode leads (11) may be located in two sealing portions, and a remaining sealing portion, not having an electrode lead (11), may be folded a plurality of times and fixed toward a region in which an electrode assembly of the battery cell (10) is accommodated.

In this case, a surface of the battery cell (10) without the sealing portion may be a bottom surface (13) of the battery cell (10).

Sealing portions of the battery cell (10) illustrated in FIG. 1 may be formed in a direction, parallel to a Z-axis, and a direction, parallel to a Y-axis, respectively, and the bottom surface (13) of the battery cell (10) may be a surface, parallel to the X-Y plane.

The bottom surface (13) of the battery cell (10) may be in contact with the close contact member (120). When the electrode lead (11) among the positive electrode lead (11a) or the negative electrode lead (11b) of the battery cell (10) is electrically connected to the resistance measuring device (130), and the close contact member (120) is also electrically connected to the resistance measuring device (130), preparations for measuring insulation performance of the battery may be completed. When voltage is applied in this state, measurement of insulation performance of the battery cell (10) may be completed.

The close contact member (120) on which the battery cell (10) is seated may be compressed and contracted by weight of the battery cell (10). A region of the close contact member (120) contacting the bottom surface (13) of the battery cell (10) may contract in a direction including a -Z direction.

The close contact member (120) may be elastic, and may be also thus in contact with a first side surface (14), which may be one side of the battery cell (10), and a second side surface (15), which may be the other side of the battery cell (10).

The battery cell (10) may include a curved region (13a) in a connection portion between the bottom surface (13) and the first side surface (14), and in a connection portion between the bottom surface (13) and the second side surface (15). The curved region (13a) may have a predetermined curvature, and a curvature value may be determined by specifications of the battery cell (10).

When the battery cell (10) is in contact with the close contact member (120) having elasticity, not only the close contact member (120) may contract due to pressure from the battery cell (10), but also a region of the close contact member (120) not pressured by the battery cell (10) may expand toward the battery cell (10).

According to the close contact member (120), a contact area between the close contact member (120) and the battery cell (10) increases, and the close contact member (120) may come into contact not only with the bottom surface (13) of the battery cell (10), but also with the curved region (13a) formed in the connection portion between the bottom surface (13) and the first side surface (14) of the battery cell (10) and in the connection portion between the bottom surface (13) and the second side surface (15) of the battery cell (10). Therefore, simply by seating the battery cell (10) to the close contact member (120), the contact area between the close contact member (120) and the battery cell (10) may be expanded. Therefore, convenience and efficiency of measuring insulation performance of the battery cell (10) may increase.

For example, when at least a portion of the entire bottom surface (13) of the battery cell (10) and the curved region (13a) forming the bottom surface (13) is defective or scratched, insulation performance of the outer case forming the battery cell (10) may be degraded. In particular, when defects or scratches are minute, measuring or identifying the same is very difficult. Therefore, the close contact member (120) may be in close contact with the entire bottom surface (13) of the battery cell (10) and the entire curved region (13a) constituting the bottom surface (13), reliability of an insulation resistance value measured by the resistance measuring device may be improved. Therefore, the presence of minute defects or scratches on the outer case of the battery cell (10) that are difficult to detect with the naked eye may be easily identified.

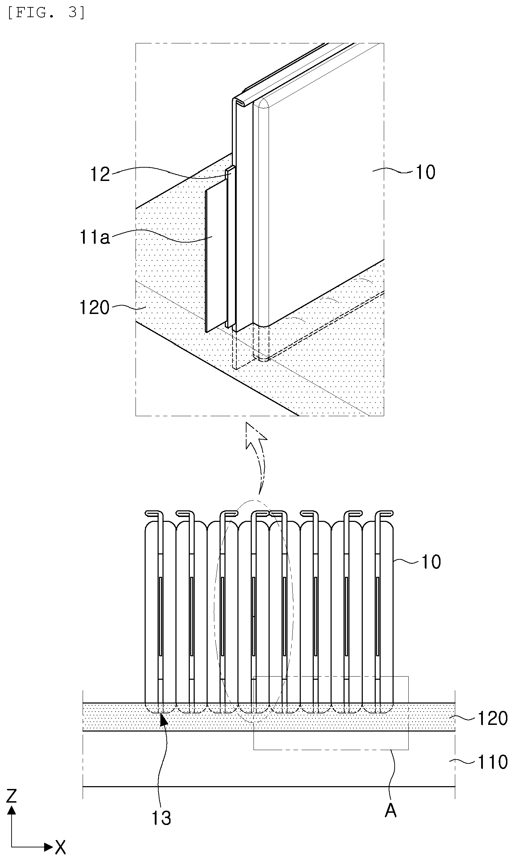

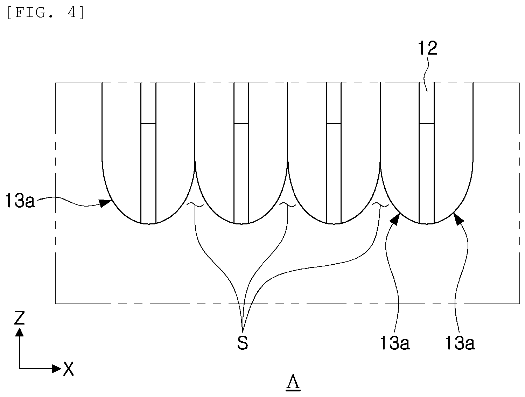

FIG. 3 schematically illustrates a state in which a plurality of battery cells (10) are seated to a close contact member (120), and FIG. 4 is an enlarged view of portion 'A' in FIG. 3.

As illustrated in FIGS. 3 and 4, an apparatus (100) for measuring insulation performance of a battery according to an embodiment of the present disclosure may measure insulation performance for a battery module (200) or a battery pack in which a plurality of battery cells (10) are stacked.

In an embodiment, the plurality of battery cells (10) may be stacked in an X-axis direction. Bottom surfaces (13) of the plurality of battery cells (10) may be disposed parallel to the X-Y plane. A curved region (13a) may follow along a bottom surface (13) of a battery cell (10). The curved region (13a) may be a region connecting both side surfaces of the battery cell (10) and the bottom surface (13), and may have a predetermined curvature.

When the plurality of battery cells (10) are stacked, side surfaces of the plurality of battery cells (10) may be in contact with each other, but curved regions (13a) of adjacent battery cells (10) may not be in contact with each other. Consequently, a gap region (S) may exist between the plurality of battery cells (10).

When the plurality of battery cells (10) are simultaneously seated, a close contact member (120) may not only contract due to own elasticity thereof, but also expand in a direction other than the first direction, which may be a direction to be pressed by the battery cells (10).

For example, as illustrated in FIG. 3, the close contact member (120) may be pressed in the -Z direction by the battery cells (10). In this case, the first direction may be the -Z direction. The close contact member (120) may contract in the - Z direction, but may expand in a direction other than the -Z direction. When the close contact member (120) expands in a direction other than the -Z direction, it may expand in a direction in contact with outer surfaces of the battery cells (10).

Degrees of expansion and contraction of the close contact member (120) may be determined by modulus of elasticity of a material constituting the close contact member (120). The modulus of elasticity may be bulk modulus of elasticity. An absolute numerical value of this modulus of elasticity is not necessarily limited by the present disclosure, and may be appropriately selected and applied depending on battery specifications, curvature of the curved region (13a), or the like. In an embodiment, modulus of elasticity of the close contact member (120) may be determined to a level such that the close contact member (120) may completely fill the gap region (S) of the plurality of battery cells (10) after a certain period of time has elapsed since the battery cells (10) have been seated.

Accordingly, the bottom surfaces (13) of the plurality of battery cells (10) and the curved region (13a) forming a portion of the bottom surface (13) of the battery cells (10) may be in contact with the close contact member (120), thereby ensuring that the entire bottom surface (13) of the battery cells (10) is electrically connected to the close contact member (120). Therefore, occurrence of a non-contact region between the battery cells (10) and the close contact member (120) may be prevented, thereby improving reliability of results of measuring insulation performance.

In an embodiment, a thickness of the close contact member (120) in the Z-axis direction may be 10 mm or more and 30 mm or less.

The thickness of the battery cell (10) seated on the close contact member (120) in the X-axis direction may be 5 mm or more and 20 mm or less. When the thickness of the battery cell (10) is 5 mm or more and 20 mm or less, a height of the curved region (13a) of the battery cell (10), that is, a curved region in a connection portion between the bottom surface (13) and a side surface of the battery cell (10), in the Z-axis direction may be more than 0 mm to 3 mm or less. When the plurality of battery cells (10) having the specifications are stacked to form the gap region (S), a height of the gap region (S) in the Z-axis direction may also be more than 0 mm to 3 mm or less. In this case, when the thickness of the close contact member (120) in the Z-axis direction is 10 mm or more and 30 mm or less, the close contact member (120) may easily fill the gap region (S). Those skilled in the art may also set an optimal thickness of the close contact member (120) by considering modulus of elasticity of the close contact member (120).

In an embodiment, a minimum height of the close contact member (120) in the Z-axis direction may be 10 mm. Accordingly, when a plurality of battery cells (10) having a thickness of 5 mm in the X-axis direction is seated on the close contact member (120), the close contact member (120) may easily fill the gap region (S) of the plurality of battery cells (10). Furthermore, even when the close contact member (120) is damaged or worn due to repeated contact between the close contact member (120) and the battery cells (10), the gap region (S) of the battery cells (10) may be sufficiently filled for a certain period of time without replacing the close contact member (120).

For example, in an operation of measuring insulation performance of a unit of the battery module (200) and the battery pack, the thickness of the close contact member (120) may be selected and applied as 30 mm. Accordingly, the close contact member (120) may easily fill the gap region (S) even in a unit of the battery module (200) and the battery pack, which have a relatively large gap region (S).

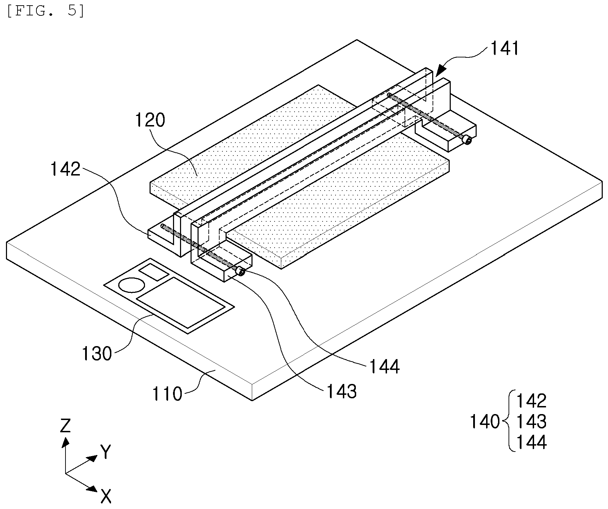

FIG. 5 is a perspective view of an apparatus (100) for measuring insulation performance of a battery according to another embodiment of the present disclosure. As illustrated in FIG. 5, an apparatus (100) for measuring insulation performance of a battery may further include a jig unit (140) including a fixation region (141) on which a battery cell (10) is seated.

The jig unit (140) may support the battery cell (10) such that a bottom surface (13) of the battery cell (10) is in contact with a close contact member (120).

The jig unit (140) may be provided such that a width of the fixation region in the X-axis direction is at least equal to a thickness of the battery cell (10) in the X-axis direction. In an embodiment, the battery cell (10) may be inserted into the fixation region (141) such that the bottom surface (13) is in contact with the close contact member (120), and one side surface and the other side surface connected to the bottom surface (13) are in contact with the jig unit (140).

In an embodiment, the jig unit (140) may be configured to allow the width of the fixation region (141) in the X-axis direction to be changed.

According to the jig unit (140) described above, the battery cell (10) may be easily fixed to the close contact member (120), and the entire bottom surface (13) of the battery cell (10) may be maintained to contact the close contact member (120). Therefore, even when an operation of measuring insulation performance continues for an extended period of time, positional shifts in the battery cell (10) may be prevented. This may contribute to improving reliability of results of measuring insulation performance of the battery cell (10).

Furthermore, according to the jig unit (140), an operation of fixing the battery cell (10) may be performed automatically without an operator having to manually fix the battery cell (10). This may contribute to improving convenience and efficiency of an operation of measuring insulation performance of the battery.

In an embodiment, the jig unit (140) may include a first support block (142) fixed to a support plate (110), a second support block (143) disposed to oppose the first support block (142) to form the fixation region (141) between the first support block (142) and the second support block (143), and a gap adjusting member (144) provided to pass through the first support block (142) and the second support block (143) in the second direction to change the width of the fixation region in the second direction.

The second direction may be a direction, parallel to the X-axis, and may be a thickness direction of the battery cell (10). The width of the fixation region (141) in the second direction may be adjusted to change a volume of the fixation region (141). Accordingly, battery cells (10) having various specifications may be inserted into the fixation region (141), and versatility of the apparatus (100) may be improved.

In an embodiment, at least one of the first support block (142) and the second support block (143) may be configured to be fixed to the support plate (110) or make sliding relative to the support plate (110) relatively difficult. The other support block may be configured to move relative to either of the fixed support blocks and the support plate (110).

For example, when an adsorbent member, a high-coefficient-of-friction rubber, or the like is provided on a contact surface between the first support block (142) and the support plate (110), the first support block (142) will have difficulty sliding relative to the support plate (110).

Since the second support block (143) may be fixed to the first support block (142), the second support block (143) may also have difficulty sliding relative to the support plate (110). Accordingly, the second support block (143) may move with respect to the first support block (142) to adjust a distance between the first support block (142) and the second support block (143) in the X-axis direction, and then the gap adjusting member (144) may be fastened to fix the distance between the first support block (142) and the second support block (143) in the X-axis direction.

In addition, in an embodiment, the first support block (142) may be completely adhered and fixed to the support plate (110) through a tape, an adhesive, or the like. this is not necessarily limited by the present disclosure, and only the second support block (143) may be configured to have difficulty in sliding with respect to the support plate (110), and the first support block (142) may move with respect to the second support block (143).

In addition, in an embodiment, the first support block (142), the second support block (143), and the gap adjusting member (144) may be formed of a material including an insulating material, thereby improving safety of the apparatus (100) for the battery cell (10).

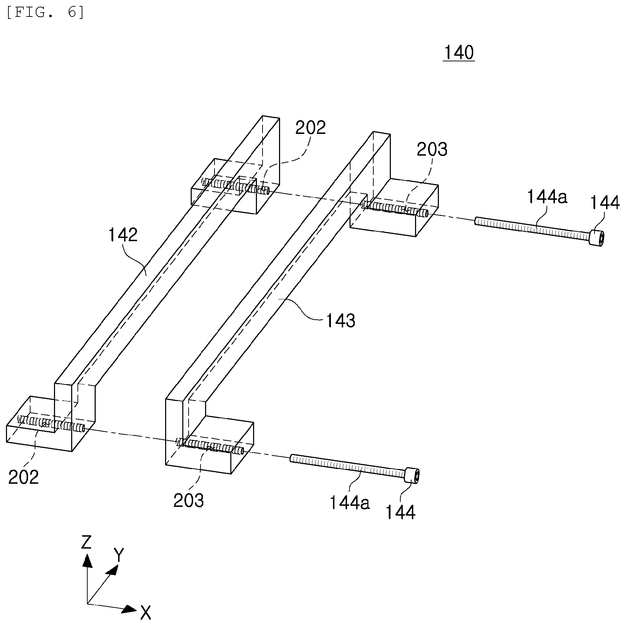

FIG. 6 is an exploded perspective view of a jig unit (140) according to an embodiment of the present disclosure. As illustrated in FIG. 6, a first support block (142) may have a first coupling hole (202) formed therein, and a second support block (143) may also have a second coupling hole (203) formed therein. The first support block (142) and the second support block (143) may be located so that the first coupling hole (202) and the second coupling hole (203) face each other and are spaced apart from each other by a certain distance. In this state, a gap adjusting member (144) may be inserted into the first coupling hole (202) and the second coupling hole (203). When the first coupling hole (202) and the second coupling hole (203) are provided in plural, the gap adjusting member (144) may also be provided in plural. When the first coupling hole (202), the second coupling hole (203), and the gap adjusting member (144) are provided in plural, coupling force between the first support block (142) and the second support block (143) may be improved.

In an embodiment, the gap adjusting member (144) may have screw threads (144a) on an outer periphery thereof. Furthermore, the first coupling hole (202) and the second coupling hole (203) may have screw grooves to engage with the screw threads (144a). Therefore, the gap adjusting member (144) may rotate clockwise in the first coupling hole (202) and the second coupling hole (203) to couple the gap adjusting member (144) and the first and second support blocks (142 and 143). Furthermore, the gap adjusting member (144) may rotate counterclockwise to detach the gap adjusting member (144) from the first coupling hole (202) and the second coupling hole (203). This allows coupling between the first support block (142) and the second support block (143) to be released.

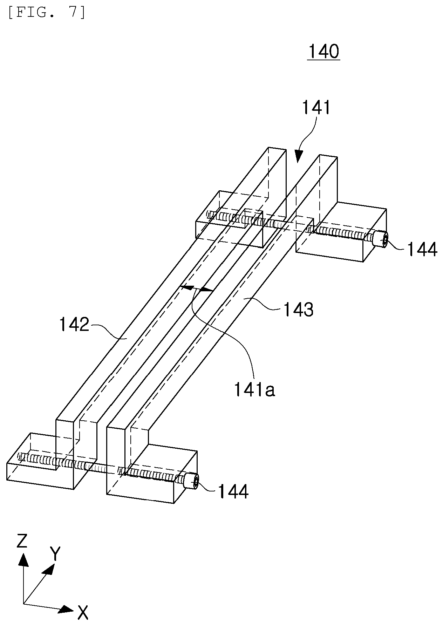

FIG. 7 is an operating status diagram of a jig unit (140) according to an embodiment of the present disclosure. As illustrated in FIG. 7, a gap adjusting member (144) may be inserted as deeply as possible into a first coupling hole (202) and a second coupling hole (203), a width of a fixation region (141) in the X-axis direction may be set to a minimum. This may be easily applied when a battery cell (10) is thin in the X-axis direction.

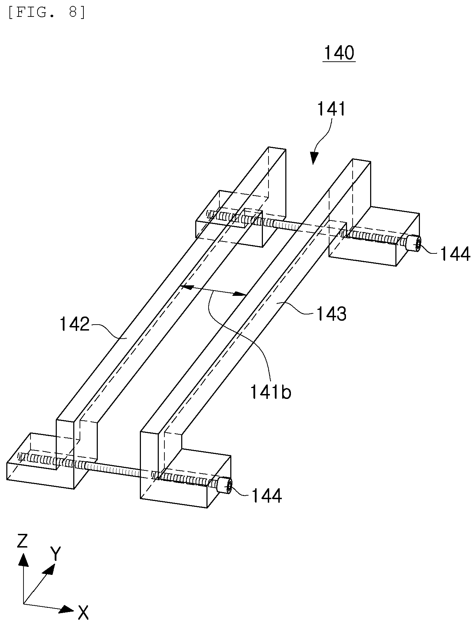

FIG. 8 is an operating status diagram of a jig unit (140) according to an embodiment of the present disclosure. As illustrated in FIG. 8, by ensuring that only a minimal region of a gap adjusting member (144) exists in a first coupling hole (202) and a second coupling hole (203), a width of a fixation region (141) in the X-axis direction may be set to a maximum. This may be easily applied when a battery cell (10) is thick in the X-axis direction.

Using the aforementioned method, the width of the fixation region (141) in the X-axis direction may be set to a value optimized for a thickness of the battery cell (10).

According to an apparatus (100) for measuring insulation performance of a battery according to an embodiment of the present disclosure, insulation performance of the battery cell (10) may be measured even when the width of the fixation region (141) in the X-axis direction exceeds the thickness of the battery cell (10) in the X-axis direction.

For example, when the width of the fixation region (141) in the X-axis direction is greater than 100% to 120% or less of the width of the battery cell (10) of which insulation performance is to be measured in the X-axis direction, the bottom surface (13) of the battery cell (10) may be placed at an angle relative to the X-Y plane.

Thereafter, the battery cell (10) may be in contact with the close contact member (120), and the close contact member (120) may be pressed by the weight of the battery cell (10). Then, the close contact member (120) may contract and expand due to elasticity thereof, and a shape of one surface of the close contact member (120), parallel to the X-Y plane, may be transformed into a shape corresponding to an outer contour of the battery cell (10). That is, even when the battery cell (10) is placed at an angle with respect to the X-Y plane, the close contact member (120) may wrap an outer surface of the battery cell (10) by a certain ratio due to elasticity thereof. Therefore, even when the bottom surface (13) of the battery cell (10) is not necessarily placed to be parallel to the X-Y plane, precision and accuracy of an operation of measuring insulation performance of the battery may be improved. Accordingly, the skill of an operator performing the operation does not affect results of measuring insulation performance of the battery.

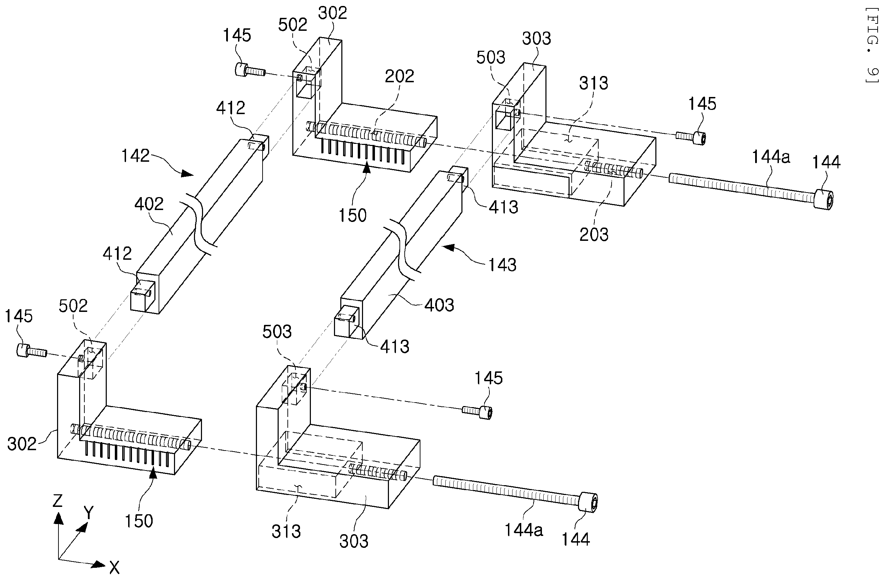

FIG. 9 is an exploded perspective view of a jig unit (140) according to another embodiment of the present disclosure. As illustrated in FIG. 9, a first support block (142) may include a pair of first side support blocks (302) and a first connection block (402) connecting the pair of first side support blocks (302). In addition, a second support block (143) may include a pair of second side support blocks (303) and a second connection block (403) connecting the pair of second side support blocks (303).

The first connection block (402) may be utilized to change a separation distance between the pair of first side support blocks (302) in the third direction, and the second connection block (403) may be utilized to change a separation distance between the pair of second side support blocks (303) in the third direction. In an embodiment, the third direction may be a width direction of the battery cell (10), i.e., a direction, parallel to the Y-axis.

Lengths of the first connection block (402) and the second connection block (403) in the third direction may be determined by a width of the battery cell (10) in the Y-axis direction, and are not necessarily limited by the present disclosure.

The first connection block (402) may be coupled to or separated from the pair of first side support blocks (302), and the second connection block (403) may also be coupled to or separated from the pair of second side support blocks (303). Accordingly, the first and second connection blocks (402, 403) may be coupled to or separated from the first and second side support blocks (302, 303). Therefore, whenever specifications of the battery cell (10) are changed, the separation distance between the pair of first side support blocks (302) in the Y-axis direction and the separation distance between the pair of second side support blocks (303) in the Y-axis direction may be adjusted by replacing the first and second connection blocks (402, 403).

Furthermore, preparations of the first and second connection blocks (402, 403) to be detachable may be usefully utilized even when partial replacement of some components constituting a jig unit (140) may be required.

In an embodiment, the first connection block (402) may include a first key block (412) protruding from a surface facing the first side support block (302) on one side, and another first key block (412) protruding from a surface facing the first side support block (302) on the other side.

Furthermore, the second connection block (403) may include a second key block (413) protruding from a surface facing the second side support block (303) on one side, and another second key block (413) protruding from a surface facing the second side support block (303) on the other side.

A first side support block (302) on one side may include a first key groove (502) into which the first key block (412) on one side is inserted, and a first side support block (302) on the other side may include another first key groove (502) into which the first key block (412) on the other side is inserted.

Furthermore, a second side support block (303) on one side may include a second key groove (503) into which the second key block (413) on one side is inserted, and a second side support block (303) on the other side may include another second key groove (503) into which the second key block (413) on the other side is inserted.

Moreover, a plurality of first key blocks (412) may be inserted into a plurality of first key grooves (502), respectively, and a plurality of second key blocks (413) may also be inserted into a plurality of second key grooves (503), respectively. Thereafter, the first connection block (402) may be coupled to the first side support block (302) by a fastening member (145) penetrating the first side support block (302) and the first key block (412).

Furthermore, the second connection block (403) may be coupled to the second side support block (303) by another fastening member (145) penetrating the second side support block (303) and the second key block (413). In an embodiment, the fastening member (145) may be provided as a bolt, a pin, or the like, and a type thereof is not necessarily limited by the present disclosure.

Furthermore, in an embodiment, at least a portion of the first side support block (302) may be inserted into the second side support block (303). The second side support block (303) may have a block groove (313) into which the first side support block (302) is inserted. The block groove (313) may be provided to be connected to a second coupling hole. Accordingly, by simultaneously passing a gap adjusting member (144) through a second coupling hole (203), the block groove (313), and a first coupling hole (202) in a state in which a portion of the first side support block (302) is inserted into the block groove (313), the first side support block (302) and the second side support block (303) may be coupled. Accordingly, coupling force between the first side support block (302) and the second side support block (303) may be improved. In this case, an electrode lead (11) of a battery cell (10) may be placed on one surface of the first side support block (302), so that a bottom surface (13) of the battery cell (10) may be in contact with the close contact member (120).

In addition, in an embodiment, a dimension measuring unit (150) may be provided on one side surface of the first side support block (302) to visually confirm dimensional information. The dimension measuring unit (150) may be provided as a ruler with a scale line. This allows an operator to visually check a separation distance between the first side support block (302) and the second side support block (303) in the X-axis direction. Therefore, the separation distance between the first side support block (302) and the second side support block (303) may be adjusted to correspond to a thickness of the battery cell (10) in the X-axis direction without any additional device. This may contribute to improving a speed of an operation of measuring insulation performance of the battery.

The dimension measuring unit (150) may be provided on at least one of the first side support block (302) and the second side support block (303), and an installation location is not necessarily limited by the present disclosure.

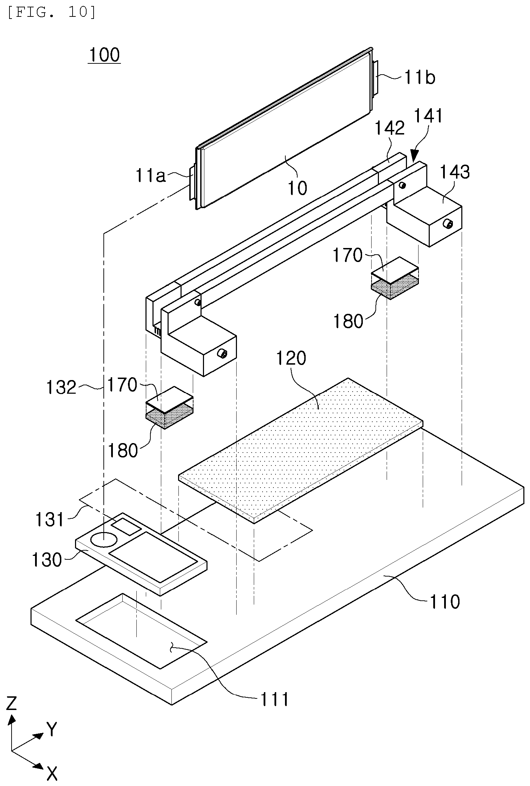

FIG. 10 is a partially exploded perspective view of an apparatus (100) for measuring insulation performance of a battery according to another embodiment of the present disclosure. As illustrated in FIG. 10, a sub-close contact member (180) may be provided on a bottom surface of a first support block (142). The sub-close contact member (180) may be formed of the same material as a close contact member (120). The sub-close contact member (180) may connect the first support block (142) and a support plate (110).

In an embodiment, an adhesive member (170) may be provided between the sub-close contact member (180) and the first support block (142), and the adhesive member (170) may serve to fix the sub-close contact member (180) to the bottom surface of the first support block (142). In an embodiment, the adhesive member (170) may be provided as a double-sided tape, but is not necessarily limited by the present disclosure.

When the sub-close contact member (180) is provided only on the bottom surface of the first support block (142), the first support block (142) becomes less able to slide relative to the support plate (110), as compared to a second support block (143).

Therefore, an effect of fixing the first support block (142) to the support plate (110) may be effectuated, and the second support block (143) becomes relatively more easily movable. Therefore, even when a bottom surface of the second support block (143) may be in contact with the support plate (110), movement may be facilitated. In this case, a thickness of the second support block (143) in the Z-axis direction may be made thicker than a thickness of the first support block (142), thereby achieving a balanced relationship between the first support block (142) and the second support block (143).

When the sub-close contact member (180) is provided on the first support block (142), movement of the first support block (142) on the support plate (110) may be restricted, but since the first support block (142) may be separated from the support plate (110) when necessary, maintenance and repair of a device may be easier, such as partially replacing only the first support block (142).

A thickness of the sub-close contact member (180) in the Z-axis direction may be at least the same as a thickness of the close contact member (120) in the Z-axis direction. Accordingly, when the bottom surface (13) of the battery cell (10) is in contact with the first support block (142) and the second support block (143), the sub-close contact member (180) may contract and expand due to the weight of the battery cell (10).

Accordingly, even when the entire bottom surface (13) of the battery cell (10) is not in contact with the close contact member (120) and some regions of the bottom surface (13) are in contact with the first support block (142) and the second support block (143), a region corresponding to a central portion of the bottom surface (13) of the battery cell (10) in the Y-axis direction may also be in contact with the close contact member (120). That is, the sub-close contact member (180) may help the bottom surface (13) of the battery cell (10) contact the close contact member (120) by expanding or contracting in the same manner as the close contact member (120).

Furthermore, in an embodiment, the support plate (110) may be provided with an installation groove (111) having a notch shape. The installation groove (111) may be a notch formed by recessing one surface of the support plate (110) in the -Z direction. At least a portion of a resistance measuring device (130) may be inserted into the installation groove (111). Accordingly, the resistance measuring device (130) may be easily installed on the support plate (110), and the resistance measuring device (130) may be fixed to the support plate (110) without a separate adhesive material or a separate fixation member.

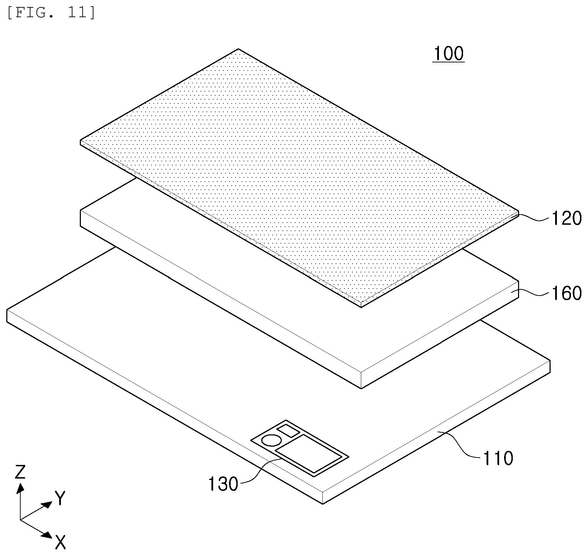

FIG. 11 is a partially exploded perspective view of an apparatus (100) for measuring insulation performance of a battery according to another embodiment of the present disclosure. As illustrated in FIG. 11, a backup member (160) may be further provided between a close contact member (120) and a support plate (110). The backup member (160) may be formed of a material having elasticity, and may include a material including an electrically conductive material.

The backup member (160) may be coupled to the close contact member (120) using an adhesive, such as a double-sided tape. An area of the backup member (160) in the X-Y plane may be at least equal to an area of the close contact member (120) in the X-Y plane.

In addition, a thickness of the backup member (160) in the Z-axis direction may be greater than a thickness of the close contact member (120) in the Z-axis direction. Furthermore, in an embodiment, the backup member (160) may be formed of a material having modulus of elasticity, lower than modulus of elasticity of the close contact member (120).

In an embodiment, the backup member (160) may be a sponge formed of insulating rubber. Since the backup member (160) has a relatively lower modulus of elasticity than the close contact member (120), a period in time it takes for it to return to an original shape thereof may be shortened, as compared to the close contact member (120).

Therefore, when the backup member (160) is deformed in the same manner as the close contact member (120) and the battery cell (10) is then removed from the close contact member (120), a speed at which the backup member (160) returns to an original state thereof may be faster than that of the close contact member (120). Therefore, restoration of the close contact member (120) fixed to the backup member (160) may also be performed more quickly by the backup member (160). This allows for rapid preparation for measuring insulation performance of the next battery cell (10).

Furthermore, since an entire region of the close contact member (120) may be restored by elasticity of the backup member (160), a phenomenon of generating a region in which the close contact member (120) is not restored to an original state thereof may be prevented. This may contribute to improving precision and accuracy of an operation of measuring insulation performance of the battery cell (10).

In an embodiment, the thickness of the close contact member (120) in the Z-axis direction may be 0.5 mm or more and 2 mm or less. In this case, when the close contact member (120) is relatively thin, the backup member (160) may share a role of the close contact member (120). That is, electrical connection may be handled by the close contact member (120), while the backup member (160) may play a greater role in contraction and expansion due to pressure exerted by the battery cells (10). Accordingly, a period in time required for elastic deformation by the battery cells (10) may be minimized.

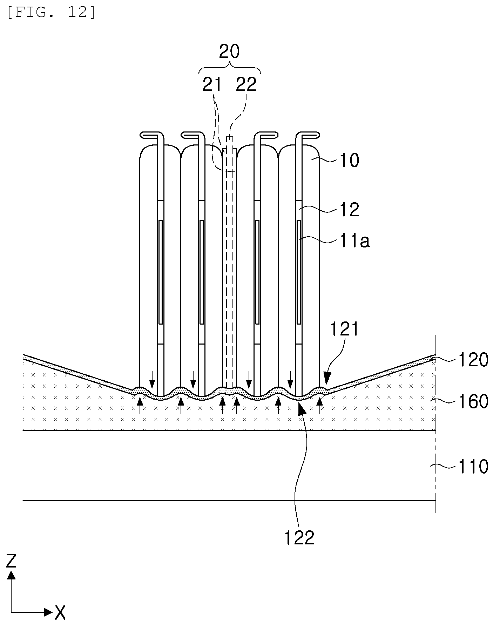

FIG. 12 schematically illustrates a state in which a plurality of battery cells (10) are seated to a close contact member (120). As illustrated in FIG. 12, when bottom surfaces (13 of FIG. 3) of a plurality of battery cells (10) are in contact with a close contact member (120), the close contact member (120) and a backup member (160) may be deformed.

The close contact member (120) and the backup member (160) may not only contract in the -Z direction to form a contraction region (122) concave in the -Z direction, but also expand in a direction, other than the -Z direction, to form an expansion region (121) protruding convexly in the +Z direction. Therefore, the close contact member (120) may fill a gap region (S in FIG. 4) of a battery cell (10). Therefore, a region corresponding to a curved region (13a in FIG. 4) on a bottom surface (13 in FIG. 3) of the battery cell (10) may also be in contact with the close contact member (120). The expansion region (121) and the contraction region (122) may be formed in the same manner in the close contact member (120) and the backup member (160). That is, the close contact member (120) may also expand in a region in which the backup member (160) expands, and the close contact member (120) may also contract in a region in which the backup member (160) contracts.

In an embodiment, the plurality of battery cells (10) may be a battery module (200) or a battery pack. A pad unit (20) may be provided between the plurality of battery cells (10) in the battery module (200) and the battery pack. The pad unit (20) may include a plurality of pad members (21) respectively contacting the plurality of battery cells (10), and a mica sheet (22) provided between the plurality of pad members (21). The pad unit (20) may provide surface pressure to the battery cells (10), and may serve to cool or insulate the plurality of battery cells (10). When the pad unit (20) is provided, the bottom surface (13) of the pad unit (20) may also be in contact with the close contact member (120). At least a portion of the close contact member (120) may also be deformed into a shape corresponding to an outer contour of the pad unit (20). Matters related to the outer contour of the pad unit (20) may be applied in the same manner as those related to an outer contour of the battery cell (10) described above.

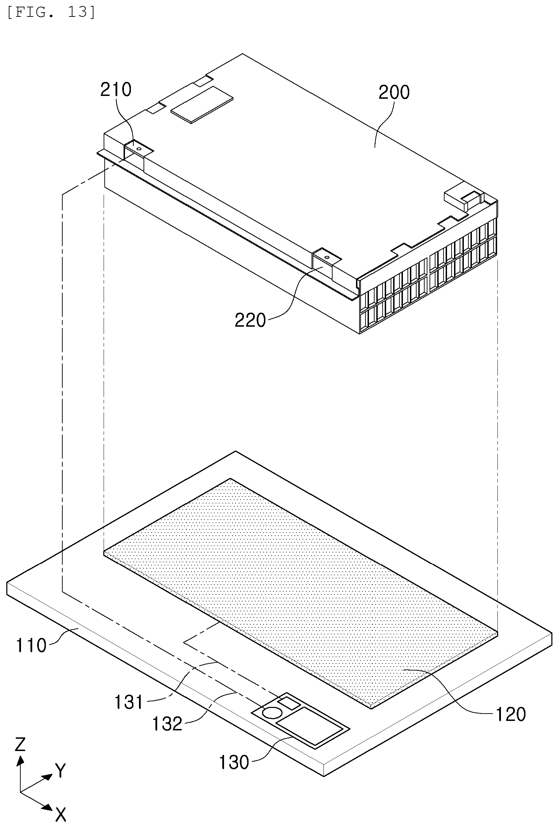

FIG. 13 schematically illustrates a state in which an apparatus (100) for measuring insulation performance of a battery according to another embodiment of the present disclosure measures insulation performance of a battery module (200). As illustrated in FIG. 13, a battery module (200) may include a first terminal portion (210) and a second terminal portion (220). The first terminal portion (210) and the second terminal portion (220) may be electrically connected to a bus bar (not illustrated). The first terminal portion (210) and the second terminal portion (220) of the battery module (200) may be exposed outside a top plate covering an upper portion of the battery module (200). The top plate may be disposed to be parallel to the X-Y plane in FIG. 13, and may be disposed in an uppermost portion in the +Z direction.

The battery module (200) may be seated on a close contact member (120) in a state in which a side plate surrounding a side surface of the battery cell (10) and a top plate covering an upper portion of the battery cell (10) are assembled, in a state in which a plurality of battery cells (10) are stacked. The side plate may cover a remaining region of a battery cell (10), except for a region covered by a bottom surface (13) and the top plate. Accordingly, the bottom surface (13) of the battery cell (10) may not be covered by the plate, and the bottom surface (13) of the battery cell (10) may be in contact with the close contact member (120).

At least a portion of the close contact member (120) may be deformed into shapes corresponding to outer contours of the plurality of battery cells (10). The outer contours of the plurality of battery cells (10) may be the border of the plurality of battery cells (10). In an embodiment, the close contact member (120) may have a form in which regions contacting the plurality of battery cells (10) copy shapes of edges of the plurality of battery cells (10). Furthermore, in an embodiment, the close contact member (120) may be recessed so that the shapes of the regions contacting the plurality of battery cells (10) may be identical to the shapes of the edges of the plurality of battery cells (10) formed in a negative shape.

According to this, insulation performance of the plurality of battery cells (10) may be measured during a process of assembling the battery module (200) without disassembling the battery module. Furthermore, since the plurality of battery cells (10) may be simultaneously in contact with the close contact member (120), insulation performance of the battery may be quickly measured in a unit of the battery module (200).

Therefore, efficiency of the process of assembling the battery module (200) may be improved, and productivity of the battery module (200) may increase. The same principle may also be applied to the battery pack.

As described above, when the battery cell (10) is seated to the close contact member (120), insulation performance of the battery may be measured by electrically connecting a first connection portion (131) of a resistance measuring device (130) to the close contact member (120) and electrically connecting a second connection portion (132) to the first terminal portion (210) or the second terminal portion (220).

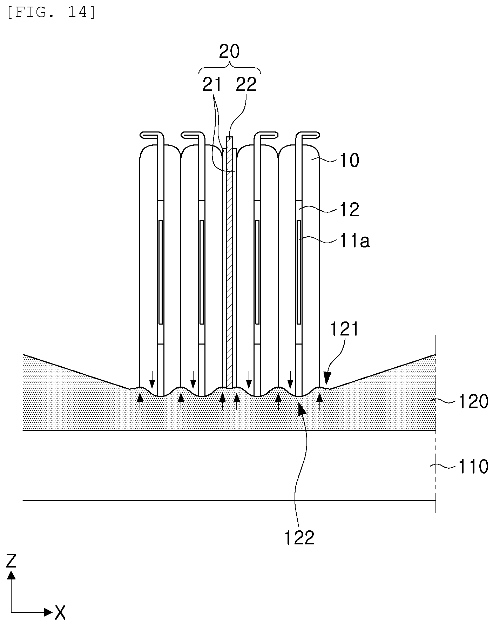

FIG. 14 schematically illustrates a state in which an apparatus (100) for measuring insulation performance of a battery according to another embodiment of the present disclosure measures insulation performance of a battery module (200). As illustrated in FIG. 14, a close contact member (120) contacting a bottom surfaces (13) of a plurality of battery cells (10) constituting a battery module (200) may be relatively thick in the Z-axis direction. In this manner, a thickness of the close contact member (120) may be appropriately selected and applied according to specifications of a battery cell (10), taking into consideration modulus of elasticity of the close contact member (120).

When modulus of elasticity of the close contact member (120) is relatively small and thus deformation is large, or when loads of the plurality of battery cells (10) are relatively large and deformation of the close contact member (120) are large, the close contact member (120) may be frequently damaged or worn. In such cases, a relatively thick close contact member (120) may be provided to prevent damage or wear of the close contact member (120).

Furthermore, when the close contact member (120) is coupled to a support plate (110) using an adhesive (not illustrated), such as a double-sided tape, and the close contact member (120) needs to be replaced, the adhesive may be removed to separate the close contact member (120) from the support plate (110). This may facilitate maintenance and repair of a device, and may extend a service life of the device.

The description may be merely an example of the application of the principles of the present disclosure. Other configurations may be added or substituted without departing from the scope of the present disclosure.

## Claims

1. An apparatus for measuring insulation performance of a battery, comprising:
a support plate including an insulated insulation region;
a close contact member disposed in the insulation region, including a material having electrical conductivity and elasticity, and in close contact with a battery cell; and
a resistance measuring device in which a first connection portion is connected to the close contact member, and in which a second connection portion is connected to a battery cell,
wherein the close contact member is pressed by the battery cell so that at least a portion of the close contact member is deformed into a shape corresponding to an outer contour of the battery cell.

2. The apparatus of claim 1, wherein a plurality of battery cells are in contact with the close contact member, and
wherein the close contact member is pressed in a first direction by the plurality of battery cells to expand in a direction, different from the first direction, to press the plurality of battery cells.

3. The apparatus of claim 2, wherein the close contact member is in contact with two or more surfaces, among surfaces of one battery cell.

4. The apparatus of claim 1, further including a jig unit including a fixation region on which the battery cell is seated, and provided to change a volume of the fixation region.

5. The apparatus of claim 4, wherein the jig unit includes:
a first support block fixed to the support plate;
a second support block disposed to oppose the first support block to form the fixation region between the first support block and the second support block; and
a gap adjusting member provided to pass through the first and second support blocks in a second direction and change a width of the fixation region in the second direction.

6. The apparatus of claim 5, wherein the first support block includes:
a plurality of first side support blocks having a first coupling hole formed therein, and the gap adjusting member inserted into the first coupling hole; and
a first connection block provided to connect the plurality of first side support blocks and change a distance between the plurality of first side support blocks in a third direction, and
the second support block includes:
a plurality of second side support blocks having second coupling holes formed therein to oppose the first coupling holes, and the gap adjusting member inserted into the second coupling holes; and
a second connection block provided to connect the plurality of second side support blocks and change a distance between the plurality of second side support blocks in the third direction.

7. The apparatus of claim 6, wherein the first connection block includes a first key block protruding from at least one surface among surfaces opposing the plurality of first side support blocks,
wherein the second connection block includes a second key block protruding from at least one surface among surfaces opposing the plurality of second side support blocks, and
wherein the first key block and the second key block are coupled to or separated from the first side support block and the second side support block.

8. The apparatus of claim 7, wherein at least one of the plurality of first side support blocks includes a first key groove into which the first key block is inserted, and
at least one of the plurality of second side support blocks includes a second key groove into which the second key block is inserted.

9. The apparatus of claim 6, wherein a screw groove is formed in a first coupling hole, and
wherein the gap adjusting member includes a screw thread corresponding to the screw groove.

10. The apparatus of claim 6, wherein at least one of the first side support block and the second side support block includes a dimension measuring unit.

11. The apparatus of claim 10, wherein the dimension measuring unit is a scale line visually displayed on at least one of the first side support block and the second side support block.

12. The apparatus of claim 2, further including a backup member provided between the support plate and the close contact member and formed of a material having elasticity.

13. The apparatus of claim 12, wherein modulus of elasticity of the backup member is less than modulus of elasticity of the close contact member.

14. The apparatus of claim 13, wherein a thickness of the backup member is greater than a thickness of the close contact member.

15. The apparatus of claim 1, wherein the close contact member includes an electrically conductive rubber.

16. The apparatus of claim 15, wherein the close contact member has a thickness of 10 mm or more and 30 mm or less.

17. The apparatus of claim 14, wherein the close contact member includes an electrically conductive rubber, and a thickness of the close contact member is 0.5 mm or more and 2 mm or less.

18. An apparatus for measuring insulation performance of a battery, comprising:
a support plate including an insulated insulation region;
a close contact member disposed in the insulation region, formed of a material having electrical conductivity and elasticity, and in close contact with a battery module including a plurality of battery cells; and
a resistance measuring device in which a first connection portion is connected to the close contact member, and in which a second connection portion is connected to a terminal portion of the battery module,
wherein the close contact member is pressed by at least one of the plurality of battery cells and a pad member disposed between the plurality of batteries, to be deformed to correspond to an outer contour of at least a portion of the plurality of battery cells and the pad member.
